# EUROPEAN PATENT SPECIFICATION

(11) **EP 3 670 697 B1**
(45) Date of publication and mention of the grant of the patent: **23.02.2022**
(21) Application number: 19216394.7
(22) Date of filing: 16.12.2019
(51) Int. Cl.: C23C 14/02, C23C 14/06, C23C 14/16, C23C 14/58, B05D 3/10, B05D 7/14, C23F 1/18

(54) **METHOD FOR THE SURFACE TREATMENT OF A METAL PRODUCT**
VERFAHREN ZUR OBERFLÄCHENBEHANDLUNG EINES METALSUBSTRATS
MÉTHODE DE TRAITEMENT DE SURFACE D'UN PRODUIT MÉTALLIQUE

(30) Priority: 20.12.2018 IT 201800020476
(43) Date of publication of application: 24.06.2020
(73) Proprietor: BB S.p.A., 59100 Prato (IT)
(72) Inventor: BARTOLETTI, Marco, 50041 CALENZANO (IT)
(74) Representative: Firmati, Leonardo

(56) References cited:
- EP-A1- 1 795 706
- WO-A1-2004/113584
- WO-A2-2004/057053
- WO-A2-2016/168649
- US-B1- 6 562 289

## Description

This invention relates to a method for the surface treatment of a metal product.

The metal product is made of brass.

Brass is a very commonly used material in the making of accessories, used, for example, in the production of bags and shoes.

This widespread use results from the physical properties, its appearance and the feeling of the brass when touched and of the relatively low price of the raw material compared with more valuable materials.

The surfaces of brass accessories are currently treated in order to improve the appearance and to protect the surface over time, for example from oxidisation phenomena.

Two methods are known for colouring accessories made of brass:
painting by the application of traditional layers of glazes or paints or the depositing of a surface layer of material by physical vapour deposition (PVD).

Both these treatments require a preliminary surface treatment of the brass item aimed at improving the adherence of the paint or of the layer of material deposited on the brass.

This preliminary treatment currently consists in a galvanic electro-depositing of a layer of binding material on the brass layer.

This layer allows a good adherence of the successive layers applied by painting or PVD and creates an excellent barrier which prevents, for example, oxidation of the brass.

Disadvantageously, galvanic electro-depositing is a very costly process to obtain and is particularly polluting as it uses materials considered to be harmful or potentially harmful, such as hexavalent chromium. Moreover, this method has the problem that the layer applied by galvanic electro-depositing tends to easily flake off if it is subjected to impacts an stresses, detaching from the main body of the accessory and causing a detachment of the layers applied on it.

Document US 6 562 289 B further describes a method for the surface treatment of a metal product, comprising the steps of providing a product made of metal, e.g. rare earth metals magnets; treating a metal surface of said product for determining and/or increase a micro-roughness on the surface, e.g. a stripping step; and applying by PVD a layer of aluminium directly on the surface of said metal substrate, wherein said stripping step is carried out with nitric acid in an 8 to 15 wt% aqueous solution for 60 seconds

In this context, the technical purpose which forms the basis of this invention is to provide a method for the surface treatment of a brass product which overcomes at least some of the above-mentioned drawbacks of the prior art.

In particular, an aim of the invention is to provide a method for the surface treatment of a brass product which is more efficient, less costly and less polluting compared with the currently known methods.

A further aim of the invention is to provide to a method for the surface treatment of a brass product which allows an accessory to be obtained equipped with surface layers fixed in a more efficient manner compared with that which can be obtained with the prior art.

The technical purpose indicated and the aims specified are substantially achieved by a method for the surface treatment of a metal product comprising the technical features described in one or more of the appended claims.

The dependent claims correspond to possible embodiments of the invention.

Further features and advantages of the invention are more apparent in the non-limiting description which follows of a preferred embodiment of a method for the surface treatment of a metal product.

The description is set out below with reference to the accompanying drawings which are provided solely for purposes of illustration without restricting the scope of the invention and in which:

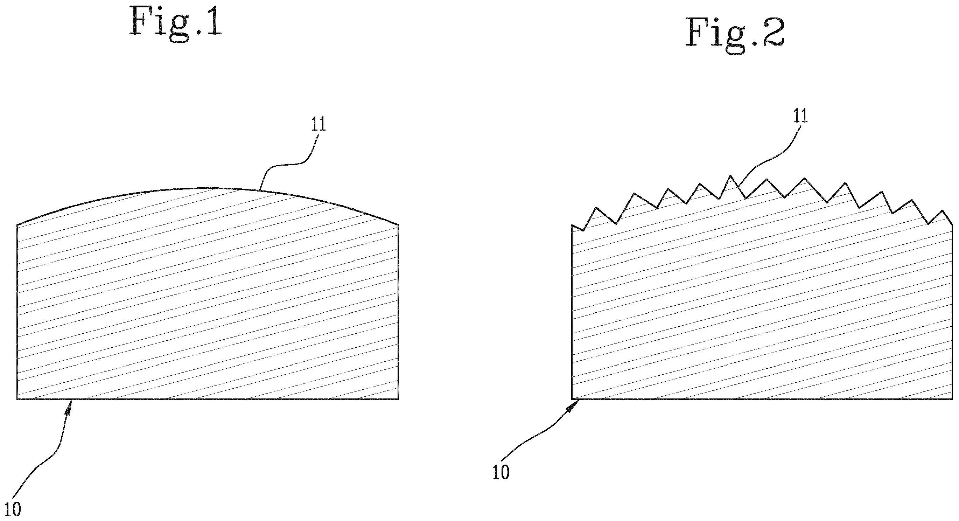

- Figures 1 to 4 show a surface portion of a metal product in accordance with successive operational phases of a method according to the invention.

The invention relates to a method for the surface treatment of a brass product 10.

The method comprises a preliminary step of preparing a product 10 made of brass, as illustrated in Figure 1.

The product 10 is in the form of a semi-worked element the shape of which is substantially definitive and has an exposed brass surface 11.

The method comprises a successive step of treating the surface 11 of the product 10 for determining or increasing a micro-roughness on it, as illustrated in Figure 2.

The step of treating the surface 11 of the product 10 comprises a step of immersing the product 10 in an acid bath.

The acid bath comprises a mixture of phosphoric acid, nitric acid and water.

In particular, the mixture comprises a percentage of between 45% and 55% of phosphoric acid, a percentage of between 4% and 6% of nitric acid and a percentage of between 40% and 50% of water.

In the preferred embodiment, the mixture comprises: 50% phosphoric acid, 5% nitric acid and 45% water.

The step of immersing the product 10 in the acid bath has a duration of between 30 seconds and 120 seconds, preferably between 60 seconds and 90 seconds.

Advantageously, the acidic mixture corrodes the surface 11 of the product 10 in a non-uniform manner and determines the creation of the required roughness.

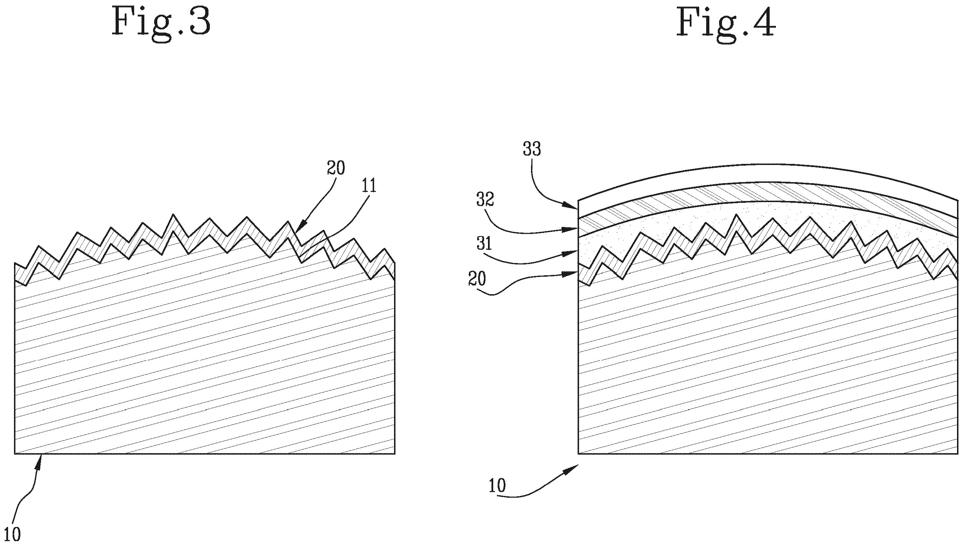

Subsequently, the method comprises a step of applying a first layer 20 on the surface 11 of the product 10 which has been treated beforehand according to the steps described above for increasing the roughness, as illustrated in Figure 3.

In accordance with the invention, the step of applying a first layer 20 on the surface 11 of the product 10 is performed by means of a process for physical vapour deposition (PVD).

According to a first embodiment, the step of applying a first layer 20 on the surface 11 comprises a determining a growth of the first layer 20 on the surface 11 up to a final thickness 5 of between 0.7 µm and 1.0 µm by cathodic atomisation (or sputtering) starting from a titanium metal target. An acetylene reactive gas is used during the cathodic atomisation process. According to this embodiment, a first layer 20 following the growth by the cathodic atomisation described above consists of black titanium carbide (TiC).

According to a second embodiment, the step of applying a first layer 20 on the surface 11 determines a growth of the first layer 20 on the surface 11 up to a final thickness of between 1.0 µm and 2.0 µm by cathodic atomisation (or sputtering) starting from a chromium metal target.

The product 10 treated as described above and having the first layer 20 of titanium carbide or chromium can be considered to be a finished product 20 (only for certain applications) or a semi-finished product for the purpose of its subsequent painting.

In the second case, the method comprises a subsequent step of painting the product 10 directly on the first layer 20 resulting from the PVD treatment described above.

Preferably, the painting step comprises the steps of:
applying a binding layer 31 directly on the first layer 20, applying a paint layer 32 on the binding layer 31 and applying a transparent layer 33 on the paint layer 32, as shown in Figure 4. More specifically, the binding layer 31 is configured to allow the binding of the paint on the first layer 20 and to guarantee the resistance of the subsequent layers deposited.

The binding layer 31 is said primer basecoat and it is preferably black or transparent depending on the aesthetic requirements.

The paint layer 32 preferably comprises a black or coloured acrylic paint depending on the aesthetic requirements and guarantees the brightness of the colours.

Lastly, the transparent layer 33 acts as protection of the lower layers and gives the final product the desired sheen characteristics.

It is the so-called primer topcoat and can be polished, semi-polished or opaque.

The invention achieves the set aim by overcoming the drawbacks of the prior art.

Advantageously, the method described allows the surface of the brass products to be coloured in a more efficient and economic manner with respect to the prior art thanks to the lower cost of the acid bath compared to galvanic electro-deposition. Moreover, the method describes avoids the use and the dispersion of hexavalent chromium.

In fact, the chromium used for the cathodic atomisation is of the non-oxidised metal type and does not offer any risks to the environment.

Lastly, in the final product obtained by means of the method described, the layers deposited have excellent properties for resistance to impact and stress and, thanks to the optimum binding provided by the rough surfaces, the layers applied on the product are less likely to detach compared with the prior art.

## Claims

1. A method for the surface treatment of a metal product comprising the steps of:
- providing a product (10) made of metal;
- treating a metal surface (11) of said product (10) for determining and/or increasing a micro-roughness on the surface (11);
- applying a first layer (20) directly on the metal surface (11) by means of a process for physical vapour deposition (PVD), **characterised in that** the step of treating a metal surface (11) comprises a step of immersing the product (10) in an acid bath comprising a mixture of phosphoric acid, nitric acid and water, wherein the product (10) is made of brass and wherein the step of immersing the product (10) in an acid bath has a duration of between 30 seconds and 120 seconds, preferably between 60 seconds and 90 seconds.

2. The method according to any one of the preceding claims, wherein the step of applying the first layer (20) on the metal surface (11) comprises a step of determining a growth of the first layer (20) on the surface (11) up to a final thickness of between 0.7 µm and 1.0 µm by cathodic atomisation starting from a titanium metal target.

3. The method according to any one of claims 1 and 2, wherein the step of applying the first layer (20) on the metal surface (11) comprises a step of determining a growth of the first layer (20) on the metal surface (11) up to a final thickness of the layer of between 1.0 µm and 2.0 µm by cathodic atomisation starting from a chromium metal target.

4. The method according to any one of the preceding claims, comprising a step of painting the product (10) directly on the first layer (20).

5. The method according to claim 4, wherein the step of painting comprises the steps of:
- applying a binding layer (31) directly on the first layer (20);
- applying a paint layer (32) on the binding layer (31);
- applying a transparent layer (33) on the paint layer (32).

## Patentansprüche

1. Verfahren zur Oberflächenbehandlung eines Metallprodukts, umfassend die Schritte:
- Bereitstellen eines Produkts (10) aus Metall;
- Behandeln einer Metalloberfläche (11) des Produkts (10) zum Bestimmen und/oder Erhöhen einer Mikrorauhigkeit auf der Oberfläche (11);
- Aufbringen einer ersten Schicht (20) direkt auf die Metalloberfläche (11) mittels eines Verfahrens zur physikalischen Dampfabscheidung (PVD), **dadurch gekennzeichnet, dass** der Schritt zum Behandeln einer Metalloberfläche (11) einen Schritt zum Eintauchen des Produkts (10) in ein Säurebad umfasst, das eine Mischung aus Phosphorsäure, Salpetersäure und Wasser umfasst, wobei das Produkt (10) aus Messing besteht und wobei der Schritt zum Eintauchen des Produkts (10) in ein Säurebad zwischen 30 Sekunden und 120 Sekunden, vorzugsweise zwischen 60 Sekunden und 90 Sekunden dauert.

2. Verfahren nach einem der vorhergehenden Ansprüche, wobei der Schritt zum Aufbringen der ersten Schicht (20) auf die Metalloberfläche (11) einen Schritt zum Bestimmen eines Wachstums der ersten Schicht (20) auf der Oberfläche (11) bis zu einer Enddicke zwischen 0,7 µm und 1,0 µm durch kathodische Zerstäubung ausgehend von einem Titanmetall-Target umfasst.

3. Verfahren nach einem der Ansprüche 1 und 2, wobei der Schritt zum Aufbringen der ersten Schicht (20) auf die Metalloberfläche (11) einen Schritt zum Bestimmen eines Wachstums der ersten Schicht (20) auf der Metalloberfläche (11) bis zu einer Enddicke der Schicht zwischen 1,0 µm und 2,0 µm durch kathodische Zerstäubung ausgehend von einem Chrommetall-Target umfasst.

4. Verfahren nach einem der vorhergehenden Ansprüche, umfassend einen Schritt zum Lackieren des Produkts (10) direkt auf die erste Schicht (20).

5. Verfahren nach Anspruch 4, wobei der Schritt zum Lackieren die Schritte umfasst:
- Aufbringen einer Bindeschicht (31) direkt auf die erste Schicht (20);
- Aufbringen einer Farbschicht (32) auf die Bindeschicht (31);
- Aufbringen einer transparenten Schicht (33) auf die Lackschicht (32).

## Revendications

1. Méthode de traitement de surface d'un produit métallique, comprenant les étapes de :
- fournir un produit (10) en métal ;
- traiter une surface métallique (11) dudit produit (10) pour déterminer et/ou augmenter une microrugosité sur la surface (11) ;
- appliquer une première couche (20) directement sur la surface métallique (11) au moyen d'un procédé de dépôt physique en phase vapeur (PVD), **caractérisée en ce que** l'étape de traitement d'une surface métallique (11) comprend une étape d'immersion du produit (10) dans un bain acide comprenant un mélange d'acide phosphorique, d'acide nitrique et d'eau, dans laquelle le produit (10) est en laiton et dans laquelle l'étape d'immersion du produit (10) dans un bain acide a une durée comprise entre 30 et 120 secondes, de préférence entre 60 et 90 secondes.

2. Méthode selon l'une quelconque des revendications précédentes, dans laquelle l'étape consistant à appliquer la première couche (20) sur la surface métallique (11) comprend une étape consistant à déterminer un gonflement de la première couche (20) sur la surface (11) jusqu'à une épaisseur finale comprise entre 0,7 et 1,0 µm par atomisation cathodique à partir d'une cible métallique en titane.

3. Méthode selon l'une quelconque des revendications 1 et 2, dans laquelle l'étape consistant à appliquer la première couche (20) sur la surface métallique (11) comprend une étape consistant à déterminer un gonflement de la première couche (20) sur la surface métallique (11) jusqu'à une épaisseur finale de la couche comprise entre 1,0 et 2,0 µm par atomisation cathodique à partir d'une cible métallique en chrome.

4. Méthode selon l'une quelconque des revendications précédentes, comprenant une étape consistant à vernir le produit (10) directement sur la première couche (20).

5. Méthode selon la revendication 4, dans laquelle l'étape de vernissage comprend les étapes de :
- appliquer une couche de liage (31) directement sur la première couche (20) ;
- appliquer une couche de vernis (32) sur la couche de liage (31) ;
- appliquer une couche transparente (33) sur la couche de vernis (32).
